# EUROPEAN PATENT SPECIFICATION

(11) **EP 0 397 311 B1**
(45) Date of publication and mention of the grant of the patent: **13.12.1995**
(21) Application number: 90303102.9
(22) Date of filing: 22.03.1990
(51) Int. Cl.: G01R 19/04, H04B 17/00, G01R 21/00, G01D 3/02, H04B 7/005

(54) **RF-power detection circuit**
Schaltung zur Erfassung von RF-Leistung
Circuit de détection de puissance RF

(30) Priority: 11.05.1989 FI 892297
(43) Date of publication of application: 14.11.1990
(73) Proprietor: NOKIA MOBILE PHONES LTD., 24101 Salo (FI)
(72) Inventor: Väisänen, Risto, SF-24100 Salo (FI); Sarasmo, Jukka, SF-24260 Salo (FI); Pekkarinen, Vesa, SF-24100 Salo (FI)
(74) Representative: Adams, William Gordon

(56) References cited:
- US-A- 4 122 400
- ELECTRONIC ENGINEERING, vol. 49, no. 598, October 1977, page 23; J. HAWKE: "Low offset peak detector circuit uses transistors"
- IBM TECHNICAL DISCLOSURE BULLETIN, vol. 21, no. 1, June 1978, pages 349-350, New York, US; P. BLYTHIN: "High frequency low offset peak hold circuit"
- IBM TECHNICAL DISCLOSURE BULLETIN, vol. 7, no. 6, November 1964, pages 533-534,
- New York, US; D.G. EAST et al.: "Universal peak sensing detection and retention device"
- INSTRUMENTS & EXPERIMENTAL TECHNIQUES, vol. 30, no. 4, part 2, July-August 1987, pages 894-895; A.P. NEVEZHIN et al.: "Wideband linear detector"

## Description

The present invention concerns the processing of the power to be obtained from a RF power sensor used in association with digital and analogous radio telephones to become a detector voltage in direct proportion to said power, said voltage being linear in the entire power range used.

In radio telephone systems, both at fixed stations and mobile stations, information has to be obtained on the transmission power of the station for controlling said power. The power control range in radio telephones is wide and numerous power levels are provided. The power levels are required to possess a great stability irrespective of temperature. Reaching and maintaining the stability is difficult, in particular at extreme temperatures; therefore, the requirements set for the power control of the means are great. The situation is most difficult when low power levels are in question. This is due to the fact that on low power levels, which are only of the order of milli watt magnitude, the voltages obtained from the sensor of the power level detector are very low. The situation becomes even more difficult if the steps of the power levels are small. For instance, the power range in the GSM system is organized only into 2 dB steps, and this results in the emphasized effect of the exponential ratio of power and voltage. For this reason, the difference of the DC voltages between adjacent small power levels obtained from the power sensor remains marginal. Hence, the power control resolution is required to be extremely wide, whereby the effect of interferences and ambient factors is emphasized. The instability of low power levels causes costs for radio telephone production, and there is a risk that owing to the effect of ageing and other factors, the radio telephone will not in the course of its life cycle meet the requirements set for its power stability.

It is known in the art to employ a circuit in which diodes are used to detect power levels. The indicated voltage from this kind of detector is in exponential ratio proportional to the power (dB) to be indicated, owing, for instance, to the specific graph of the diode. This, in turn, results in that on low power levels, small power variations cause a change in the output of the detector which is barely discernible, so that the above mentioned problems still exist.

An example of a detection circuit using diodes which charge a capacitor to a voltage indicative of power level is disclosed in US Patent No. 4,122,400, to which the preamble of present claim 1 relates. Resistors are provided to discharge the capacitor with a relatively long time constant, and in this particular disclosure diodes are used to detect both forward and reverse power for a measurement of standing wave ratio (VSWR), and consequential control of the transmitted power.

The present invention provides a circuit in which the relation between transmitter power and the output of the detector circuit tends to be more linear, by which the aforementioned drawbacks tend to be eliminated. By use of the circuit of the invention, the differential voltages between adjacent power levels are significantly more indicative of differential power over the entire power range to be measured than when a diode detector is used.

The invention provides a circuit for providing a voltage proportional to the output of an RF power sensor used for measuring transmission power of a transmitter, said circuit being supplied from a supply voltage terminal and including a capacitor providing said voltage between its terminals, a rectifier coupled to receive power obtained from the RF power sensor and coupled to the capacitor to charge it during positive half cycles of the power received from the power sensor, discharge of said capacitor via a first resistance commencing as the power received from the power sensor decreases,
characterised in that said rectifier is a first transistor acting as an active rectifier said first transistor being biassed by a second transistor of the same type, the output of the power sensor being coupled to the base of the first transistor, the base and collector of the second transistor being connected to each other and commonly connected via a second resistance to the supply voltage terminal and via a third resistance to the base of the first transistor so as to bias the first transistor into conduction even on the lowest levels of power obtained from the power sensor.

Insofar as the active rectifier charges the capacitor with a current which is proportional to the power being measured, the voltage across the capacitor will tend to be proportional to such power. The first transistor is so biassed that its input impedance is independent of the level of the signal at the output of the power sensor, and it is conductive even when the output of the power sensor is minimal.

Active rectifiers are known in the art, and an example thereof is disclosed in Electron Engineering, Vol. 49, no. 598, page 23. However this circuit is used for a peak detector and does not include the manner of biassing found in the present invention.

An embodiment of the circuit of the invention will be described in more detail with reference to the accompanying drawings, in which:
Fig. 1 presents a principle coupling of the circuit, and
Fig. 2 presents a response graph of the circuit and a response graph of the circuit executed with diodes.

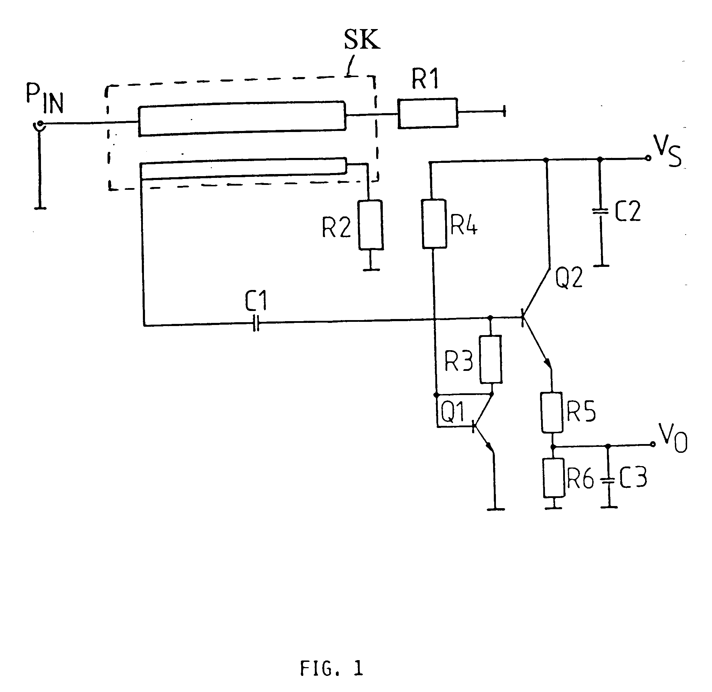

As shown in Fig. 1, a directional switch SK is used for the power sensor. The directional switch may be in design micro-strip, a strip line or a coaxial switch. A resistance R2 not only adapts the directional switch but also draws the power coupled to the directional switch from the power reflecting from the load towards the transmitter. As an active rectifier is used a transistor Q2, which charges a capacitor C3 from the supply voltage Vs of the circuit of the invention. To the base of the transistor Q2 is carried the power obtained from the directional switch SK. For biasing the transistor Q2, a similar transistor Q1 is used, which is coupled to be a diode. The bias transistor Q1 receives current through a resistor R4 from the supply voltage Vs of the circuit. Since the base and the collector of the transistor are coupled together, a small quantity of current is supplied to the base of the transistor acting as the rectifier, whereby the transistor Q2 is biased for a small, about 100 »A of idle current, and the base emitter voltage of the transistor Q2 is very small, about 80 mV.

Since the transistors Q1 and Q2 are of the same type, the base emitter voltages are same and no other temperature compensation is needed. The time constant T = R6xC3 of the capacitor C3 charged by the transistor is selected to be such that it is a lot greater than the cycle time of the power Pin.

The circuit of the invention operates as follows.

The directional switch is so coupled that when positive power travels in the direction of the resistance R1, power of equal size is induced to the other gate of the switch and flows in the direction of the transistor Q2. In the ascending part of the positive half cycle of the power Pin the transistor Q2 starts to conduct and charges the capacitor C3 through the resistor R5 rapidly. The control signal Pin is not loaded by said charging of the capacitor C3 because the charging current is obtained directly from the supply voltage Vs. Respectively, in the descending part of the power Pin, the transistor Q2 acting as the rectifier ceases from conducting because the charge remaining in the poles of the capacitor is affective on the emitter thereof. The capacitor C3 now discharges slowly through the resistor R6 of the emitter circuit of the transistor Q2. The time constant T = R6xC3 of the discharge is selected to be far greater than the cycle time of the power Pin. The output voltage Vo of the detector, which is proportional to the power Pin, is obtained from the capacitor C3.

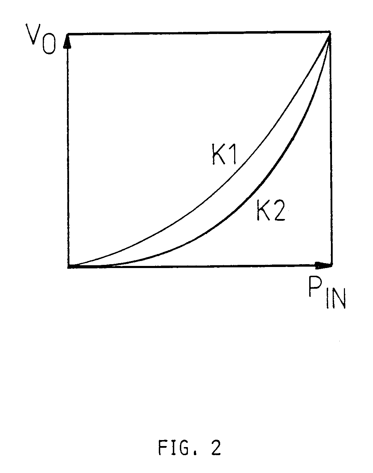

By biasing the transistor Q2 of the invention with transistor Q1 being of the same type a sufficient temperature compensation is obtained and, above all, the result that when the transistor Q2 is biased for a small idle current of about 100 »A, it is conductive even on the smallest power levels. The response graph of the circuit remains straight irrespective of the temperature, whereas the response graph of the circuit known in the art, being carried out with diodes, is a parable in shape due e.g. to the specific graph of the diode, and is dependent on the temperature (graph K2 in Fig. 2). As is shown in Fig. 2, a change of the power Pin in the circuit known in the art causes on low power levels conforming to the response graph K2 of the circuit known in the art only an insignificant change in the output voltage Vo of the detector, whereas with the circuit of the invention, a change of the voltage Vo caused by a change of the power level is substantially less dependent on whether small or great power levels are employed. The response is therefore more linear than in using a diode detector.

By the circuit of the invention the defects of the circuits of prior art are eliminated. The circuit is temperature-compensated in a simple fashion, and the circuit consists of few simple components, and is therefore inexpensive and easy to manufacture in automated production. The range of the circuit dynamics is extensive. The circuit of the invention may be used advantageously in analogous and digital radio telephone systems at mobile and fixed stations, but it may also be used in other circuits of power detectors.

## Claims

1. A circuit for providing a voltage (Vo) proportional to the power from an RF power sensor (SK) used for measuring transmission power (Pin) of a transmitter, said circuit being supplied from a supply voltage terminal (Vs) and including a capacitor (C3) providing said voltage (Vo) between its terminals, a rectifier coupled to receive power obtained from the RF power sensor (SK) and coupled to the capacitor (C3) to charge it during positive half cycles of the power received from the power sensor (SK), discharge of said capacitor (C3) via a first resistance (R6) commencing as the power received from the power sensor (SK) decreases,
characterised in that said rectifier is a first transistor (Q2) acting as an active rectifier, said first transistor (Q2) being biassed by a second transistor (Q1) of the same type, the output of the power sensor (SK) being coupled to the base of the first transistor (Q2), the base and collector of the second transistor (Q1) being connected to each other and commonly connected via a second resistance (R4) to the supply voltage terminal (Vs) and via a third resistance (R3) to the base of the first transistor (Q2) so as to bias the first transistor (Q2) into conduction even on the lowest levels of power obtained from the power sensor (SK).

2. A circuit according to claim 1 wherein the joined base/collector of the second transistor (Q1) is so coupled to the base of the first transistor (Q2) that the base-emitter voltage of the first transistor (Q2) is of the order of 80 mV, and the idle current of the first transistor (Q2) is of the order of 100 »A.

3. A circuit according to claim 1 or claim 2 wherein the first transistor (Q2) is coupled to charge the capacitor (C3) via a fourth resistance (R5) by a current drawn from the supply voltage terminal (Vs).

4. A circuit according to claim 3 wherein the fourth and first resistances (R5, R6) are such that the capacitor (C3) is charged rapidly and discharged slowly.

5. The combination of a circuit according to any preceding claim and an RF transmitter, said power sensor (SK) being arranged to receive power from said RF transmitter in use.

6. The combination of a circuit according to claim 4 and an RF transmitter, said power sensor (SK) being arranged to receive power from said RF transmitter in use, and said capacitor (C3) being discharged with a time constant considerably greater than the period of the transmitted power.

## Patentansprüche

1. Schaltung zur Erzeugung einer Spannung (Vo), die proportional zur Leistung eines RF-Leistungssensors (SK) ist, der zur Messung der Übertragungsleistung (Pin) eines Senders benutzt wird, wobei die Schaltung über einen Spannungsversorgungsanschluß (Vs) versorgt wird und einen Kondensator (C3), zwischen dessen Anschlüssen die Spannung (Vo) liegt, sowie einen Gleichrichter aufweist, der vom RF-Leistungssensor (SK) erhaltene Leistung empfängt und mit dem Kondensator (C3) gekoppelt ist, um ihn während der positiven Halbwellen der vom Leistungssensor (SK) empfangenen Leistung zu laden, wobei die Entladung des Kondensators (C3) über einen ersten Widerstand (R6) beginnt, wenn die vom Leistungssensor (SK) empfangene Leistung abfällt, **dadurch gekennzeichnet,** daß der Gleichrichter ein erster Transistor (Q2) ist, der als aktiver Gleichrichter arbeitet, der erste Transistor (Q2) von einem zweiten Transistor (Q1) derselben Art vorgespannt wird, der Ausgang des Leistungssensors (SK) mit der Basis des ersten Transistors (Q2) gekoppelt ist, und die Basis sowie der Kollektor des zweiten Transistors (Q1) miteinander verbunden und zusammen über einen zweiten Widerstand (R4) an den Spannungsversorgungsanschluß (VS) und über einen dritten Widerstand (R3) an die Basis des ersten Transistors (Q2) angeschlossen sind, um den ersten Transistor (Q2) auch bei kleinsten vom Leistungssensor (SK) erhaltenen Leistungspegeln in Leitung vorzuspannen.

2. Schaltung nach Anspruch 1, **dadurch gekennzeichnet**, daß der mit der Basis zusammengeschlossene Kollektor des zweiten Transistors (Q1) so mit der Basis des ersten Transistors (Q2) gekoppelt ist, daß die Basisemitterspannung des ersten Transistors (Q2) in der Größenordnung von 80 mV und der Ruhestrom des ersten Transistors (Q2) in der Größenordnung von 100 »A liegt.

3. Schaltung nach Anspruch 1 oder 2, **dadurch gekennzeichnet**, daß der erste Transistor (Q2) den Kondensator (C3) über einen vierten Widerstand (R5) mit einem dem Spannungsversorgungsanschluß (VS) entnommenen Strom lädt.

4. Schaltung nach Anspruch 3, **dadurch gekennzeichnet**, daß der vierte und der erste Widerstand (R5, R6) so gewählt sind, daß der Kondensator (C3) schnell geladen und langsam entladen wird.

5. Kombination der Schaltung nach einem der vorhergehenden Ansprüche mit einem RF-Sender, bei der der Leistungssensor (SK) vom im Betrieb befindlichen RF-Sender Leistung empfängt.

6. Kombination der Schaltung nach Anspruch 4 mit einem RF-Sender, bei der der Leistungssensor (SK) vom im Betrieb befindlichen RF-Sender Leistung empfängt und der Kondensator (C3) mit einer Zeitkonstanten entladen wird, die wesentlich größer als die Periode der gesendeten Leistung ist.

## Revendications

1. Circuit destiné à procurer une tension (Vo) proportionnelle à la puissance provenant d'un capteur de puissance en radiofréquence (SK) utilisé pour mesurer la puissance d'émission (Pin) d'un émetteur, ledit circuit étant alimenté à partir d'une borne de tension d'alimentation (Vs) et comprenant un condensateur (C3) procurant ladite tension (Vo) entre ses bornes, un redresseur couplé de façon à recevoir la puissance obtenue à partir du capteur de puissance en radiofréquence (SK) et couplé au condensateur (C3) afin de le charger pendant les demi-cycles positifs de la puissance reçue depuis le capteur de puissance (SK), la décharge dudit condensateur (C3) par l'intermédiaire d'une première résistance (R6) commençant lorsque la puissance reçue depuis le capteur de puissance (SK) décroît,
caractérisé en ce que ledit redresseur est un premier transistor (Q2) agissant comme un redresseur actif, ledit premier transistor (Q2) étant polarisé par un second transistor (Q1) du même type, la sortie du capteur de puissance (SK) étant couplée à la base du premier transistor (Q2), la base et le collecteur du second transistor (Q1) étant reliés l'un à l'autre et reliés en commun par l'intermédiaire d'une seconde résistance (R4) à la borne de tension d'alimentation (Vs) et par l'intermédiaire d'une troisième résistance (R3) à la base du premier transistor (Q2) de façon à polariser le premier transistor (Q2) en conduction, même aux niveaux les plus bas de la puissance obtenue depuis le capteur de puissance (SK).

2. Circuit selon la revendication 1 dans lequel les base/collecteur réunis du second transistor (Q1) sont couplés à la base du premier transistor (Q2) de telle manière que la tension base émetteur du premier transistor (Q2) est de l'ordre de 80 mV et que le courant de repos du premier transistor (Q2) est de l'ordre de 100 »A.

3. Circuit selon la revendication 1 ou la revendication 2 dans lequel le premier transistor (Q2) est couplé de façon à charger le condensateur (C3) par l'intermédiaire d'une quatrième résistance (R5) au moyen d'un courant extrait de la borne de tension d'alimentation (Vs).

4. Circuit selon la revendication 3 dans lequel les quatrième et première résistances (R5, R6) sont telles que le condensateur (C3) se charge rapidement et se décharge lentement.

5. Combinaison d'un circuit selon l'une quelconque des revendications précédentes et d'un émetteur en radiofréquence, ledit capteur de puissance (SK) étant agencé afin de recevoir de la puissance dudit émetteur en radiofréquence utilisé.

6. Combinaison d'un circuit selon la revendication 4 et d'un émetteur en radiofréquence, ledit capteur de puissance (SK) étant agencé de façon à recevoir de la puissance à partir dudit émetteur en radiofréquence utilisé, et ledit condensateur (C3) étant déchargé avec une constante de temps considérablement plus grande que la période de la puissance émise.
